Europäisches Patentamt

European Patent Office

Office européen des brevets

(11) Veröffentlichungsnummer: **0 387 943**
**A1**

# EUROPÄISCHE PATENTANMELDUNG

(21) Anmeldenummer: **90200528.9**

(22) Anmeldetag: **07.03.90**

(51) Int. Cl.⁵: **C23C 16/44, C23C 14/22**

(30) Priorität: **11.03.89 DE 3907963**

(43) Veröffentlichungstag der Anmeldung:
**19.09.90 Patentblatt 90/38**

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**

**Groenewoudseweg 1**
**NL-5621 BA Eindhoven(NL)**

(84) **FR GB NL**

(72) Erfinder: **Rau, Hans, Prof., Dr.**
**Brunnenstrasse 11**
**D-5100 Aachen(DE)**

(74) Vertreter: **Piegler, Harald, Dipl.-Chem. et al**
**Philips Patentverwaltung GmbH**
**Wendenstrasse 35 Postfach 10 51 49**
**D-2000 Hamburg 1(DE)**

(54) **Verfahren und Vorrichtung zur Dosierung einer dampfförmigen Substanz in einen Reaktor.**

(57) Bei der Dosierung einer dampfförmigen Substanz in einen Reaktor (7) wird ein Trägergas in einem Sättiger (1), der auf einer konstanten Temperatur gehalten wird, mit der zu dosierenden Substanz (4) gesättigt. Das entstandene Gasgemisch wird durch eine beheizte Kapillare (5) zu dem Reaktor (7) geleitet. Eine genaue Dosierung von wenig flüchtigen und/oder chemisch aggressiven Substanzen wird dadurch ermöglicht, daß die Kapillare (5) auf einer Temperatur gehalten wird, die gleich der Temperatur im Sättiger (1) oder höher als die Temperatur im Sättiger (1) ist, und daß der Druck im Sättiger (1) konstant und höher als der Druck im Reaktor (7) gehalten wird.

Fig.1

EP 0 387 943 A1

## Verfahren und Vorrichtung zur Dosierung einer dampfförmigen Substanz in einen Reaktor

Die Erfindung betrifft ein Verfahren zur Dosierung einer dampfförmigen Substanz in einen Reaktor, wobei ein Trägergas in einem Sättiger, der auf einer konstanten Temperatur gehalten wird, mit der zu dosierenden Substanz gesättigt wird und das entstandene Gasgemisch durch eine beheizte Kapillare zu dem Reaktor geleitet wird, und eine Vorrichtung zur Durchführung des Verfahrens.

Eine Vorrichtung der eingangs genannten Art ist aus JP-A-63-119 537 bekannt. Bei dieser Vorrichtung ist die Kapillare spiralförmig ausgebildet und in einer siedenden Flüssigkeit angeordnet. Der Dampfdruck der dampfförmigen Substanz wird durch die Temperatur der siedenden Flüssigkeit genau eingestellt.

Die kontinuierliche Dosierung einer Substanz in einen Reaktor ist ein Problem, wenn diese Substanz wenig flüchtig ist, d.h. einen niedrigen Dampfdruck besitzt, und/oder chemisch sehr aggressiv ist. Gemeint sind hier Substanzen, die bei 373 K, der oberen Funktionsgrenze konventioneller Durchflußregler, einen niedrigeren Dampfdruck als etwa 200 hPa haben, insbesondere solche, die derartige Dampfdrücke erst bei wesentlich höheren Temperaturen erreichen. Chemische Agressivität kann ein Problem sein, wenn die zu dosierende Substanz mit den Materialien, aus denen herkömmliche Durchflußregler gebaut sind (Edelstahl, O-Ring-Materialien), nicht verträglich ist.

Der Erfindung liegt die Aufgabe zugrunde, eine genaue Dosierung von wenig flüchtigen und/oder chemisch aggressiven Substanzen zu ermöglichen.

Diese Aufgabe wird erfindungsgemäß dadurch gelöst, daß bei einem Verfahren der eingangs genannten Art die Kapillare auf einer Temperatur gehalten wird, die gleich der Temperatur im Sättiger oder höher als die Temperatur im Sättiger ist, und daß der Druck im Sättiger konstant und höher als der Druck im Reaktor gehalten wird.

Vorzugsweise wird der Druck im Sättiger mindestens zehnmal so hoch wie der Druck im Reaktor gehalten.

Das Trägergas wird vorzugsweise über einen Druckregler in den Sättiger eingeleitet.

Die Erfindung betrifft auch eine Vorrichtung zur genauen Dosierung einer dampfförmigen, insbesondere einer wenig flüchtigen Substanz in einen Reaktor. Sie besteht im wesentlichen aus drei Teilen:

1.) einem Sättiger, in dem ein Trägergas (z.B. Argon) mit der zu dosierenden Substanz gesättigt wird,

2.) einer beheizbaren Kapillare, die den Sättiger mit einem Reaktor verbindet, und

3.) einem Druckregler, der es erlaubt, im Sättiger einen gewollten Druck zeitlich konstant zu halten.

Dem Ein- und Ausschalten des Dosierungsstromes dient vorzugsweise eine Umwegleitung für das Trägergas, die vom Eingang des Sättigers direkt zum Reaktor führt.

Der Druckregler wird ausgeschaltet, wenn die Umwegleitung geöffnet wird. Es fließt dann ein gewisser Trägergasstrom z.B. über ein Nadelventil des Druckreglers. Man könnte das Ventil auch ganz schließen.

Im Reaktor wird die dampfförmige Substanz Gasphasenreaktionen und/oder Reaktionen an der Oberfläche von Substraten unterworfen, insbesondere zur Beschichtung von Substraten, aber auch zur Herstellung von pulverförmigen Materialien, etwa als Ausgangsmaterialien für keramische Produkte.

Ausführungsbeispiele der Erfindung sind in einer Zeichnung dargestellt und werden im folgenden näher beschrieben. In der Zeichnung zeigen

Fig. 1 eine Dosiervorrichtung in schematischer Darstellung,

Fig. 2 und Fig. 3 Diagramme, aus denen der Zusammenhang zwischen dosierter Menge und Druck im Sättiger hervorgeht.

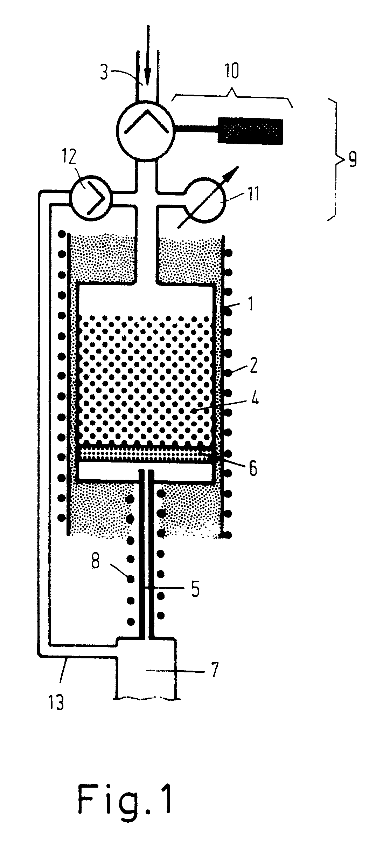

Fig. 1 zeigt einen Sättiger 1, der mit einer Heizvorrichtung 2 auf einer konstanten Temperatur gehalten wird und in dem ein Trägergas, z.B. Argon, mit der zu dosierenden Substanz gesättigt wird. Dazu wird das durch einen Pfeil angedeutete Trägergas über eine Zuleitung 3 in den Sättiger 1 eingeleitet. Geeignete Bauarten eines derartigen Sättigers für feste Substanzen müssen gewährleisten, daß stets eine genügend große Oberfläche der zu verdampfenden Substanz dem Trägergas ausgesetzt ist. Daher verwendet man zur Füllung des Sättigers zweckmäßig ein Gemisch 4 eines inerten Materials, z.B. Quarzsand, mit der pulverisierten Substanz. Die Mischung soll einen kleinen Strömungswiderstand haben (verglichen mit dem einer später noch näher erläuterten Kapillare 5). Die inerte Beimengung soll eine Verkleinerung des Porenvolumens der Mischung durch Zusammensintern, wodurch sich der Strömungswiderstand der Mischung erhöhen würde, weitgehend verhindern. Außerdem soll sie eine gleichmäßige Verteilung des Trägergases auf den ganzen Querschnitt der Mischung bewirken. Das Gemisch 4 liegt auf einer porösen Platte 6 innerhalb des Sättigers 1.

Im Falle, daß die zu dosierende Substanz eine Flüssigkeit ist, eignet sich als Sättiger ein sogenannter "Bubbler" (nicht dargestellt), bei dem das Trägergas in Form kleiner Bläschen durch die Flüssigkeit perlt.

Das entstandene Gasgemisch wird durch die Kapillare 5 zu einem Reaktor 7 geleitet. Die Kapillare 5 muß dabei z.B. durch eine Zusatzheizung 8 auf einer Temperatur gehalten werden, die gleich der oder höher als die Temperatur im Sättiger 1 ist. Solange der Druck im Sättiger 1 durch einen Druckregler 9 (der in bzw. an der Zuleitung 3 angeordnet und z.B. durch ein motorgetriebenes Nadelventil 10 und einen Druckmesser 11 zu dessen Steuerung realisiert ist) konstant und höher als der Druck im Reaktor 7 gehalten wird, fließt durch die Kapillare 5 ein konstanter Gasstrom. Dieser hat einen konstanten Gehalt an zu dosierender Substanz, wenn die Temperatur im Sättiger 1 ebenfalls konstant ist. Dabei ist der Druck im Reaktor 7 ebenfalls als konstant vorausgesetzt. Diese Bedingung kann fallengelassen werden, wenn der Druck im Reaktor wesentlich niedriger ist als der im Sättiger, z.B. unter 10 % des Druckes im Sättiger.

Die Dosierung kann praktisch gestoppt werden, indem ein Ventil 12 in einer Umwegleitung 13 geöffnet wird, die das Trägergas vom Druckregler 9 direkt in den Reaktor 7 leitet. Dabei sollte der Regelmechanismus des Druckreglers ausgeschaltet werden und der Trägergasstrom gestoppt oder auf einen kleinen Wert eingestellt werden. Dadurch geht die Druckdifferenz zwischen Sättiger 1 und Reaktor 7 praktisch auf Null zurück. Wenn der Sättigungsdruck der zu verdampfenden Substanz niedriger ist als der Druck im Reaktor 7, kann der Dampf der zu dosierenden Substanz nur noch durch Diffussion durch die Kapillare 5 gelangen, was wegen der Kleinheit der infragekommenden Querschnittsfläche der Kapillare mehrere Größenordnungen kleinere Flüsse als mit Trägergasstrom bedeutet.

Eine Änderung der zu dosierenden Menge läßt sich auf zwei verschiedene Weisen erreichen: Entweder durch eine Änderung der Druckdifferenz zwischen Sättiger 1 und Reaktor 7 oder durch eine Änderung der Temperatur des Sättigers 1, wodurch sich der Gehalt an zu dosierender Substanz im Trägergas ändert.

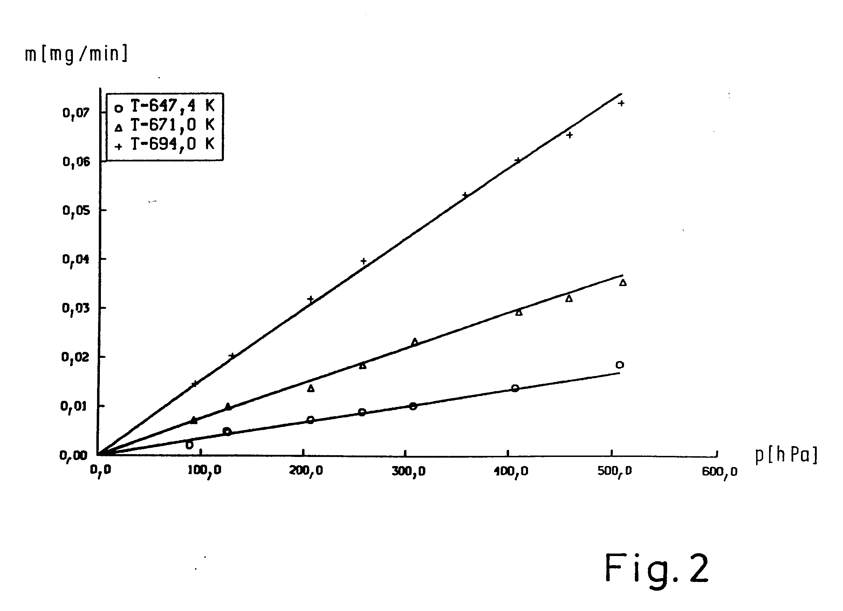

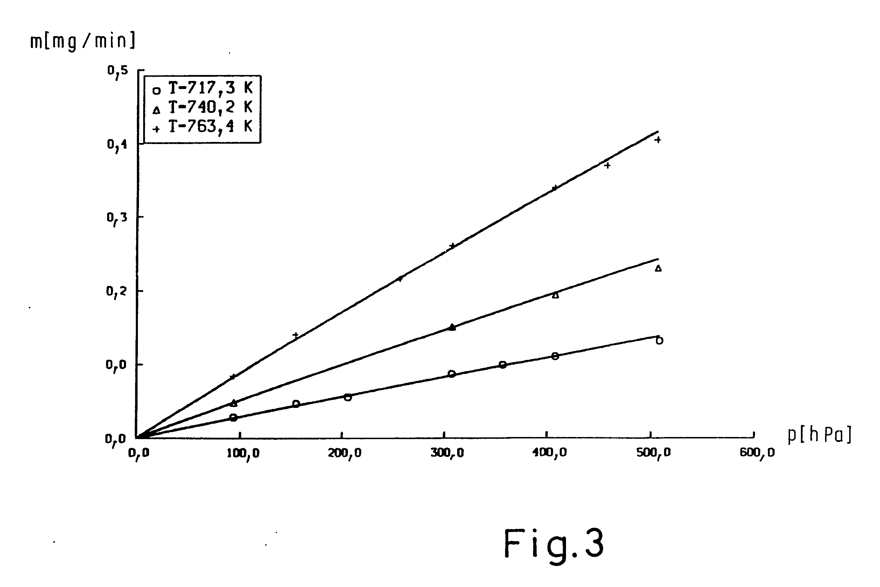

Die Vorrichtung wurde in einem Beispiel getestet. Dabei wurde Zinkdampf als zu dosierende Substanz und Argon als Trägergas benutzt. Die Fig. 2 und 3 zeigen die dosierten Mengen m an Zink (mg/Minute) in Abhängigkeit vom Druck p im Sättiger 1 (hPa) mit der Temperatur T des Sättigers als Parameter. Der Druck im Reaktor 7 betrug etwa 10 % des Druckes im Sättiger.

Die erfindungsgemäße Vorrichtung kann für eine ganze Reihe von Substanzen verwendet werden. Beispiele hierfür sind Elemente (P, As, S, Se, Te usw.), Metallhalogenide (z.B. $AlCl_3$, $BiCl_3$, $FeCl_3$, $GaCl_3$, $InCl$, $MoCl_5$, $NbCl_5$, $SbCl_3$, $ScCl_3$, $SnCl_2$, $TaCl_5$, $ThCl_2$, $TlCl$, $WCl_6$, einige Oxide , Sulfide sowie zahlreiche metallorganische Verbindungen.

Als Material für Sättiger und Kapillare kommt z.B. Quarzglas (im Beispiel verwendet) oder auch ein geeignetes Metall, z.B. Edelstahl oder Platin (-Legierungen), infrage. Eine obere Temperaturgrenze ist nur durch die Stabilität dieser Baumaterialien gegeben.

Der Druck im Sättiger muß, wie gesagt, höher als der im Reaktor sein, vorzugsweise zehnmal so hoch. Da durch die Kapillare ständig Gasgemisch (Trägergas plus Dampf der wenig flüchtigen Substanz) in den Reaktor abfließt, muß die Regelvorrichtung diesen Verlust ständig ausgleichen und dabei, wie schon gesagt, den Druck im Sättiger genau konstant halten. Die Temperatur im Sättiger muß ebenfalls konstant sein, wenn eine gleichbleibende Dosierung der wenig flüchtigen Substanz gewährleistet sein soll. Die Temperatur der Kapillare muß mindestens so hoch sein wie die im Sättiger, um jegliche Kondensation der wenig flüchtigen Substanz in der Kapillare zu vermeiden.

Wenn diese Bedingungen eingehalten werden, so ist die in der Zeiteinheit in den Reaktor dosierte Menge wenig flüchtiger Substanz zeitlich konstant. Sie kann leicht geändert werden, indem entweder der Druck oder die Temperatur (oder beides) im Sättiger geändert werden. In günstigen Fällen wird ein beinahe linearer Zusammenhang zwischen dosierter Menge und Druck im Sättiger beobachtet (siehe Fig. 2 und 3). Voraussetzung dafür ist, daß der Druck im Sättiger etwa zehnmal so hoch ist wie der im Reaktor, sonst ist die Abhängigkeit zwischen dosierter Menge an wenig flüchtiger Substanz und dem Druck im Sättiger schwächer als linear. Bei einer Änderung der Temperatur im Sättiger ändert sich die dosierte Menge an wenig flüchtiger Substanz exponentiell mit der reziproken absoluten Temperatur (Dampfdruckkurve der wenig flüchtigen Substanz). Die Dosierung der wenig flüchtigen Substanz kann praktisch gestoppt werden, indem der Druck im Sättiger dem Druck im Reaktor gleichgemacht wird.

## Ansprüche

1. Verfahren zur Dosierung einer dampfförmigen Substanz in einen Reaktor, wobei ein Trägergas in einem Sättiger, der auf einer konstanten Temperatur gehalten wird, mit der zu dosierenden Substanz gesättigt wird und das entstandene Gasgemisch durch eine beheizte Kapillare zu dem Reaktor geleitet wird,
dadurch gekennzeichnet, daß die Kapillare auf einer Temperatur gehalten wird, die gleich der Temperatur im Sättiger oder höher als die Temperatur im Sättiger ist, und daß der Druck im Sättiger konstant und höher als der Druck im Reaktor gehalten wird.

2. Verfahren nach Anspruch 1,
dadurch gekennzeichnet, daß der Druck im Sättiger mindestens zehnmal so hoch wie der Druck im Reaktor gehalten wird.

3. Verfahren nach Anspruch 1 oder 2,
dadurch gekennzeichnet, daß das Trägergas über einen Druckregler in den Sättiger eingeleitet wird.

4. Vorrichtung zur Durchführung des Verfahrens nach Anspruch 3 mit einem Sättiger, in dem ein Trägergas mit der zu dosierenden Substanz gesättigt wird, und einer beheizbaren Kapillare, die den Sättiger mit einem Reaktor verbindet,
gekennzeichnet durch einen Druckregler (9), der es erlaubt, im Sättiger (1) einen gewollten Druck zeitlich konstant zu halten.

5. Vorrichtung nach Anspruch 4,
gekennzeichnet durch eine Umwegleitung (13) für das Trägergas, die vom Eingang des Sättigers (1) direkt zum Reaktor (7) führt.

Fig.1

Fig. 2

EP 0 387 943 A1

2-III-PHD 89-042

00528.9

Fig.3

3-III-PHD 89-042

## EINSCHLÄGIGE DOKUMENTE

EP 90200528.9

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| P,X | <u>EP - A1 - 0 325 319</u> (PHILIPS PATENTVERWALTUNG) * Ansprüche 1,6; Fig. 1; Spalte 3, Zeile 19 - Spalte 4, Zeile 52; Spalte 5, Zeilen 38-43 * | 1,3 | C 23 C 16/44 C 23 C 14/22 |
| X | & JP-A-1-266 801 | | |
| X | <u>DE - C - 1 221 520</u> (UNION CARBIDE) * Ansprüche; Fig. 1 * | 1 | |
| A | PATENT ABSTRACTS OF JAPAN, unexamined applications, E Sektion, Band 12, Nr. 367, 30. September 1988 THE PATENT OFFICE JAPANESE GOVERNMENT Seite 143 E 664 | 1 | |
| D,A | * Kokai-Nr. 63-119 537 (FUJITSU LTD) * | | |

RECHERCHIERTE SACHGEBIETE (Int Cl⁵)

C 23 C 16/00
C 23 C 14/00
H 01 L 21/00

Der vorliegende Recherchenbericht wurde für alle Patentansprüche erstellt.

| Recherchenort WIEN | Abschlußdatum der Recherche 01-06-1990 | Prüfer KÖRBER |
|---|---|---|